# EUROPÄISCHE PATENTANMELDUNG

(11) **EP 3 250 010 A1**
(43) Veröffentlichungstag der Anmeldung: **29.11.2017**
(21) Anmeldenummer: 17162118.8
(22) Anmeldetag: 21.03.2017
(51) Int. Cl.: H05K 1/02, H05K 1/14, H05K 3/28, H05K 3/30, H05K 3/36

(54) **ELEKTRONISCHES STEUERMODUL UND VERFAHREN ZUR HERSTELLUNG EINES ELEKTRONISCHEN STEUERMODULS**

(30) Priorität: 25.05.2016 DE 102016209141
(71) Anmelder: Robert Bosch GmbH, 70442 Stuttgart (DE)
(72) Erfinder: Liskow, Uwe, 71679 Asperg (DE)

(57) **Zusammenfassung**

Die Erfindung betrifft ein elektronisches Steuermodul (1) mit einem Leiterplatten-Trägersubstrat (2), auf dem elektronische Bauelemente (10, 11, 12) einer elektronischen Steuerschaltung angeordnet sind und mit einem zum Schutz der elektronischen Steuerschaltung auf dem Leiterplatten-Trägersubstrat (2) über den elektronischen Bauelementen (10, 11, 12) angeordneten Harzverguss (3), wobei der Harzverguss (3) ein die elektronischen Bauelemente (10, 11, 12) abdeckendes und gegenüber dem Außenraum schützendes, hartes Gehäuseteil (7) bildet. Das Steuermodul weist wenigsten eine Leitungsanbindung (14) an eine außerhalb des Harzvergusses (3) angeordnete elektrische Komponente (6) des Steuermoduls (1) auf, wobei die wenigstens eine Leitungsanbindung (14) eine flexible Leiterfolie (4, 4a 4b) umfasst, wobei die flexible Leiterfolie (4, 4a, 4b) mit einem ersten Endabschnitt (46) an eine innerhalb des Harzvergusses (3) auf dem Leiterplatten-Trägersubstrat (2) angeordnete elektrische Kontaktstelle (13) elektrisch angebunden ist, wobei ein sich an den ersten Endabschnitt (46) anschließender Verbindungsabschnitt (47) der flexiblen Leiterfolie (4, 4a 4b) durch den Harzverguss (3) hindurch und wenigstens abschnittsweise in direkten Kontakt zu dem Harzverguss (3) nach außen geführt ist und wobei ein sich an den Verbindungsabschnitt (47) anschließender zweiter Endabschnitt (48) der flexiblen Leiterfolie (4, 4a, 4b) außerhalb des Harzvergusses (3) mit der elektrischen Komponente (6) elektrisch verbunden ist. Weiterhin wird ein Verfahren zur Herstellung eines solchen elektronischen Steuermoduls beschrieben.

## Beschreibung

### Stand der Technik

In der Kraftfahrzeugtechnik werden elektronische Steuermodule zur Ansteuerung verschiedener elektrischer Aktuatoren verwandt. Derartige Steuermodule werden insbesondere am oder im Getriebe verbaut und dienen dort beispielsweise der Ansteuerung elektrohydraulischer Druckregelventile. Außer einer elektronischen Steuerschaltung weisen derartige elektronische Steuermodule Kontaktierungsmittel für Aktuatoren, Sensoren, Steckerteile oder Stellmotoren auf, die an oder auf einem Grundträger angeordnet sein können. Auch werden die Sensoren und Steckerteile ganz oder teilweise an dem Grundträger angeordnet.

Sensoren und Stecker können mittels Schrauben oder Nietverbindungen an dem Grundträger befestigt oder in diesen integriert werden. Die aus den Sensoren ragenden Anschlüsse werden dabei in als Grundträger dienende Leiterplatten-Trägersubstrate oder flexible Leiterfolien eingesteckt und/oder angelötet oder sind an Stanzgitter geschweißt oder gelötet. Die Stanzgitter, flexiblen Leiterfolien oder Leiterplatten verbinden die Sensoren und Stecker mit einer zentralen elektronischen Steuerschaltung zur Ansteuerung des Getriebes, der sogenannten TCU (Transmission Control Unit). Die Lage der Sensoren und Steckerteile an dem Grundträger ist bei den bekannten Steuermodulen durch die geometrische Gestaltung der Stanzgitter oder der flexiblen Leiterfolien vorbestimmt. Bei starren Leiterplatten als Grundträger können die Sensoren bei einer erforderlichen Designänderungen zwar grundsätzlich neu auf der Leitierplatte positioniert werden, jedoch scheitert dies oft an den erforderlichen Befestigungsschrauben und Nieten, die Flächen und Freiraum auf der Leiterplatte benötigen.

Aus der DE 10 2011 088 969 A1 ist ein elektronisches Steuermodul mit einem Leiterplatten-Trägersubstrat als Grundträger bekannt, auf dem elektronische Bauelemente einer elektronischen Steuerschaltung angeordnet sind. Zum Schutz der elektronischen Steuerschaltung ist über den elektronischen Bauelementen ein Harzverguss auf dem Leiterplatten-Trägersubstrat aufgetragen. Der Harzverguss aus Epoxidharz bildet ein die elektronischen Bauelemente abdeckendes und gegenüber dem Außenraum schützendes, hartes Gehäuseteil. Die Anbindung von außerhalb des Harzvergusses angeordneten elektrischen Komponenten des Steuermoduls an die elektronische Steuerschaltung erfolgt über Leiterbahnen des Leiterplatten-Trägersubstrats.

Ferner ist aus der EP 1 842 407 B1 ein elektronisches Steuermodul bekannt, bei dem zur Leistungsanbindung einer unter einem Gehäusedeckelteil angeordneten Steuerschaltung an außerhalb eines Gehäuseraumes an einem Trägerteil angeordnete elektrische Komponenten eine flexible Leiterfolie eingesetzt wird. Die Steuerschaltung ist über Bonddrähte mit der flexiblen Leiterfolie kontaktiert und auf einem an dem Träger angeordneten Bodenteil angeordnet und dort mit einem Schutzgel abgedeckt. Da das in diesem Fall allein der Passivierung dienende Schutzgel auch nach dem Aushärten zum Schutz der Schaltung gegenüber mechanischen Beanspruchungen und aggressiven Medien nicht ausreicht, ist ein separater Gehäusedeckel aus Metall oder Kunststoff über dem Schutzgel erforderlich.

### Offenbarung der Erfindung

Die Erfindung bezieht sich auf ein elektronisches Steuermodul, vorzugsweise auf ein elektronisches Getriebesteuermodul, das für die Ansteuerung eines Kraftfahrzeuggetriebes geeignet ist. Das elektronische Steuermodul umfasst ein Leiterplatten-Trägersubstrat, auf dem elektronische Bauelemente einer elektronischen Steuerschaltung angeordnet sind. Weiterhin weist das Steuermodul einen zum Schutz der elektronischen Steuerschaltung auf dem Leiterplatten-Trägersubstrat über den elektronischen Bauelementen angeordneten Harzverguss auf, der ein die elektronischen Bauelemente abdeckendes und gegenüber dem Außenraum schützendes, hartes Gehäuseteil bildet. Vorteilhaft ist wenigstens eine Leitungsanbindung an eine außerhalb des Harzvergusses angeordnete elektrische Komponente des Steuermoduls in Form einer flexiblen Leiterfolie ausgebildet, die mit einem ersten Endabschnitt an eine innerhalb des Harzvergusses auf dem Leiterplatten-Trägersubstrat angeordnete elektrische Kontaktstelle elektrisch angebunden ist. Ein sich an den ersten Endabschnitt anschließender Verbindungsabschnitt der flexiblen Leiterfolie ist durch den Harzverguss hindurch und wenigstens abschnittsweise in direkten Kontakt zu dem Harzverguss nach außen geführt. Ein sich an den Verbindungsabschnitt anschließender zweiter Endabschnitt der flexiblen Leiterfolie ist außerhalb des Harzvergusses mit der elektrischen Komponente elektrisch verbunden.

Weiterhin bezieht sich die Erfindung auf ein Verfahren zur Herstellung eines elektronischen Steuermoduls mit folgenden Schritten:
- Bereitstellen eines Leiterplatten-Trägersubstrats, auf dem elektronische Bauelemente einer elektronischen Steuerschaltung angeordnet ist,
- Bereitstellen wenigstens einer Leitungsverbindung, wobei die wenigstens eine Leitungsverbindung eine flexible Leiterfolie umfasst,
- Herstellung eines elektrischen Kontaktes zwischen einem ersten Endabschnitt der flexiblen Leiterfolie und einer auf dem Leiterplatten-Trägersubstrat angeordneten elektrischen Kontaktstelle,
- Herstellung eines Harzvergusses, der über den elektronischen Bauelementen und der elektrischen Kontaktstelle auf dem Leiterplatten-Trägersubstrat aufgetragen wird, wobei der Harzverguss nach seiner Herstellung ein die elektronischen Bauelemente und die Kontaktstelle abdeckendes und gegenüber dem Außenraum schützendes hartes Gehäuseteil bildet und wobei ein sich an den ersten Endabschnitt der flexiblen Leiterfolie anschließender Verbindungsabschnitt der flexiblen Leiterfolie durch den Harzverguss hindurch und wenigstens abschnittsweise in direkten Kontakt zu dem Harzverguss nach außen absteht und
- Herstellen einer elektrischen Verbindung zwischen einem sich an den Verbindungsabschnitt anschließenden zweiten Endabschnitt der flexiblen Leiterfolie und einer elektrischen Komponente außerhalb des Harzvergusses.

### Vorteile der Erfindung

Das erfindungsgemäße elektronische Steuermodul ermöglicht es vorteilhaft, die Lage der Sensoren, Steckerteile und gegebenenfalls weiterer elektrischer Komponenten an dem elektronischen Steuermodul im Falle einer Designänderung oder Variantenbildung in einfacher Weise zu verändern, indem zur Leitungsanbindung der Komponenten flexible Leiterfolien eingesetzt werden. Bei notwendigen Designänderungen der Lage oder der Ausrichtung von Sensoren auf dem elektronischen Steuermodul kann diese Änderung in sehr kurzer Zeit umgesetzt werden, da vorteilhaft nur das Layout des Leiterplatten-Trägersubstrats angepasst werden muss. Dies erfordert sehr viel weniger Zeit als bei den bekannten Stanzgittermodulen. Zum Schutz der elektronischen Steuerschaltung dient vorteilhaft ein Harzverguss aus einem vorzugsweise duroplastischen Werkstoff, beispielsweise Epoxidharz. Der Harzverguss schützt die elektronischen Bauelemente der elektronischen Steuerschaltung einerseits gegen das aggressive Getriebefluid, andererseits wird durch den Harzverguss ein stabiles und hartes Gehäuseteil gebildet, das die Steuerschaltung vor mechanischen Einwirkungen wie Stößen und der Ablagerung von Metallspänen ausreichend schützt. Ein separates Deckelteil ist daher nicht erforderlich. Vorteilhaft können die über die Leitungsanbindung kontaktierten Komponenten auch noch nach der Fertigstellung der harzvergossenen Steuerschaltung montiert und kontaktiert werden. Es ist nicht erforderlich, die Sensoren oder Stecker und andere Komponenten, welche oft nicht mit gängigen Leiterplatten-Bestückungsvorrichtung auf die Leiterplatten aufgebracht werden können, zusammen mit den elektronischen Bauelementen der Steuerschaltung auf dem Leiterplatten-Trägersubstrat zu bestücken.

Vorteilhaft wird somit ein optimaler Schutz der Steuerschaltung gegen im Getriebeöl enthaltene Späne oder aggressive Getriebefluide in Kombination mit einer flexiblen Anbindung der Steuerschaltung an die außerhalb des Harzvergusses angeordneten elektrischen Komponenten ermöglicht. Hierzu wird die flexible Leiterfolie vorteilhaft zumindest abschnittsweise in den Harzverguss mit einbezogen. Die durch den direkten Kontakt der Leiterfolie mit dem Harzverguss bewirkte Abdichtung ist ausreichend um ein Eindringen von Getriebefluid entlang der Leitungsanbindung bis zu der Steuerschaltung zu vermeiden.

Vorteilhafte Ausführungsformen und Weiterbildungen der Erfindung werden durch die in den abhängigen Ansprüchen beschriebenen Merkmale ermöglicht.

Besonders vorteilhaft ist es, wenn die als Leitungsanbindung verwandte flexible Leiterfolie wenigstens eine erste Lage aus einer flexiblen Trägerfolie aus glasfaserverstärktem Harz, wenigstens eine zweite Lage mit auf der Trägerfolie aufgebrachten Leiterbahnen und eine dritte Lage aus einer Deckschicht aus einem glasfaserverstärktem Harz, einer Harzschicht oder einem Harzlack aufweist. Insbesondere ist es vorteilhaft, wenn das in dem Harzverguss enthaltene Harz, das in der flexiblen Trägerfolie enthaltene Harz und das Harz oder der Harzlack der Deckschicht das gleiche Harzmaterial, insbesondere ein Epoxidharz aufweisen. Die elektrische Kontaktierung zwischen den außerhalb des Harzvergusses angeordneten Komponenten und der elektronischen Steuerschaltung muss mediendicht ausgestaltet sein. Wenn das zur Herstellung des Gehäuseteils verwandte Harzmaterial und das Material der die Außenseiten der flexiblen Leiterfolie bildenden Trägerfolie und/oder Deckschicht das gleiche Harzmaterial umfassen, wird vorteilhaft durch die starke chemische Vernetzung des Harzmaterials eine besonders feste und dichte Verbindung zwischen den Außenseiten der flexiblen Leiterfolie und dem als Gehäuseteil fungierenden Harzverguss hergestellt. Der durch den Harzverguss hindurchgeführte Abschnitt der flexiblen Leiterfolie ist daher vorteilhaft an seinen Außenseiten äußerst mediendicht in den Harzverguss eingebettet, so dass keine aggressiven Stoffe durch einen Spalt zwischen der flexiblen Leiterfolie und dem Harzverguss bis zur elektronischen Steuerschaltung vordringen können.

Weiterhin ist es vorteilhaft, dass innerhalb des mit dem Harzverguss abgedeckten Teils des Leiterplatten-Trägersubstrats wenigstens ein Sockelteil auf dem Leiterplatten-Trägersubstrat angeordnet ist und dass der Verbindungsabschnitt der flexiblen Leiterfolie an dem Sockelteil angeordnet, insbesondere gefestigt ist. Das Sockelteil kann beispielsweise preisgünstig als thermoplastisches Bauteil oder auch aus Metall ausgebildet sein. Da die als Leitungsanbindung verwandte flexible Leitierfolie bereits durch den Harzverguss ausreichend abdichtet, muss das Sockelteil keine Abdichtaufgaben übernehmen. Das Sockelteil dient daher vorzugsweise der mechanischen Befestigung und benötigt keine dichte Verbindung zum Harzverguss. Eventuell vorhandene Toleranzen des Sockelteils können in einfacher Weise durch die flexible Leiterfolie ausgeglichen werden.

Besonders vorteilhaft ist es, wenn an dem Sockelteil eine Führungsfläche ausgebildet ist, an welche der Verbindungsabschnitt der flexiblen Leiterfolie fest anliegt. Dies kann beispielsweise durch eine Klebung erreicht werden. Durch die feste Anlage der flexiblen Leiterfolie an der Führungsfläche wird diese automatisch in die vorbestimmte Richtung gebogen und dadurch vorteilhaft der Austrittswinkel und/oder der Austrittsort der flexiblen Leiterfolie aus dem Harzverguss bestimmt. Dies erleichtert die spätere Kontaktierung der außerhalb des Harzvergusses platzierten elektrischen Komponenten mit der flexiblen Leiterfolie und daher den Gesamtaufbau des elektronischen Steuermoduls.

Das auf dem Leiterplatten-Trägersubstrat angeordnete Sockelteil kann vollständig in den Harzverguss integriert werden. Insbesondere vorteilhaft ist jedoch eine Ausführungsform, bei der das Sockelteil durch den Harzverguss nach außen hindurchgeführt ist und eine von dem Leiterplatten-Trägersubstrat abgewandte Montagefläche des Sockelteils von dem Harzverguss ausgenommen ist. In diesem Fall kann eine elektrische Komponente, beispielsweise ein an einem Podest angeordneter Sensor, in einfacher Weise an dem Sockelteil befestigt werden, indem das Podest an der Montagefläche des Sockelteils fixiert wird. Es ist dann nicht erforderlich, Freiflächen auf dem Leiterplatten-Trägersubstrat mit dem Harzverguss auszusparen, was relativ aufwändig wäre und außerdem unnötig Bauraum beanspruchen würde. Ebenso ist es nicht erforderlich, Anschlussstifte der Sensoren in Durchsteckmontage an dem Leiterplatten-Trägersubstrat zu befestigen und in Kontaktierungsöffnungen zu verlöten. Daher werden auch keine Abdeckkappen auf der Unterseite des Leiterplatten-Trägersubstrats für die Anschlussstifte benötigt, um diese gegen Kurzschlüsse zu schützen.

Die Podeste können beispielsweise an dem Sockelteil einfach angeschraubt werden oder über Rastmittel, Kleber, Nieten, Schweißverbindungen oder andere Befestigungsmittel an dem Sockelteil befestigt werden.

Vorteilhaft ist weiterhin das oben beschriebene Herstellungsverfahren zur Herstellung eines elektronisches Steuermoduls, da Designänderungen der Lage oder Ausrichtung von Sensoren auf dem elektronischen Steuermodul in sehr kurzer Zeit auf preiswerte Weise umgesetzt werden können. Vorteilhaft muss hierzu im Wesentlichen nur das Layout des Leiterplatten-Trägersubstrats angepasst werden.

In der Fertigung kann die flexible Leiterfolie mit dem Verbindungsabschnitt an dem Sockelteil angeordnet, insbesondere dort befestigt werden, bevor der elektrische Kontakt zwischen dem ersten Endabschnitt der flexiblen Leiterfolie und der auf dem Leiterplatten-Trägersubstrat angeordneten elektrische Kontaktstelle hergestellt wird. Das Sockelteil kann dann zusammen mit der flexiblen Leiterfolie auf das Leiterplatten-Trägersubstrat bestückt werden. Es ist aber auch möglich, zunächst die Sockelteile auf dem Leiterplatten-Trägersubstrat zu bestücken und dann erst die jeweilige flexible Leiterfolie an dem zugeordneten Sockelteil zu fixieren.

Für eine vollautomatischen Fertigung von elektronischen Steuermodulen erlaubt das erfindungsgemäße Herstellungsverfahren in zuverlässiger und preiswerter Weise höchste Flexibilität und Anpassung an Designwünsche und Änderungswünsche des Kunden in Kombination mit einer zuverlässigen Kapselung und Abdichtung der elektronischen Steuerschaltung.

### Kurze Beschreibung der Zeichnungen

Es zeigen:
Fig. 1 einen Querschnitt durch ein elektronisches Steuermodul für ein erstes Ausführungsbeispiel der Erfindung,
Fig. 2 einen Ausschnitt aus dem Querschnitt von Fig. 1 während der Herstellung des Moduls,
Fig. 3 einen Teilquerschnitt durch eine als Leistungsanbindung verwandte flexible Leiterfolie.

### Ausführungsformen der Erfindung

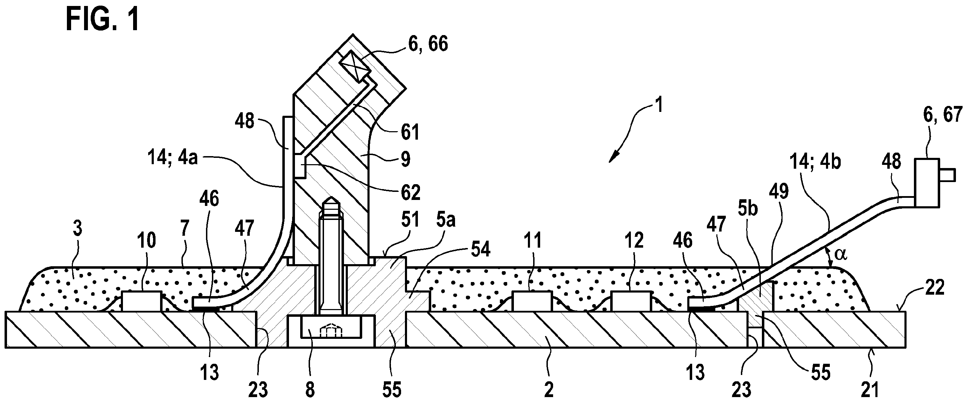

Fig. 1 zeigt einen Querschnitt durch ein elektronisches Steuermodul 1, welches vorzugsweise in oder an einem Getriebe zur Ansteuerung von Getriebeaktuatoren wie elektrohydraulischen Druckregelventilen verwandt werden kann. Die Erfindung ist aber nicht auf Getriebesteuermodule beschränkt und kann auch bei Steuermodulen zur Ansteuerung anderer Anwendungen eingesetzt werden. Das elektronische Steuermodul 1 weist ein starres Leiterplatten-Trägersubstrat 2 auf. Bei dem Leiterplatten-Trägersubstrat 2 kann es sich um eine gewöhnliche Leiterplatte (PCB = Printed Circuit Board) handeln, beispielsweise eine FR4-Leiterplatte oder höherwertig, welche eine oder mehrere Leiterbahnlagen aufweist und als Trägermaterial der im Außenbereich und zwischen den Leiterbahnlagen angeordneten Isolierlagen glasfaserverstärkten Epoxidharz verwendet. Die beispielsweise aus Kupfer bestehenden Leiterbahnen unterschiedlicher Lagen des Leiterplatten-Trägersubstrats 2 können in bekannter Weise über metallische Durchkontaktierungen oder Zwischenverbinder (sogenannte ViAs) untereinander verbunden sein. Das Leiterplatten-Trägersubstrat 2 weist eine als Bestückungsseite vorgesehene erste Seite 22 und eine davon abgewandte zweite Seite 21 auf. Auf der ersten Seite 22 ist das Leiterplatten-Trägersubstrat mit elektronischen Bauelementen 10, 11 und 12 bestückt. Die elektronischen Bauelemente 10, 11, 12 können sowohl als ungehäuste "bare-die"-Bauelemente auf das Leiterplatten-Trägersubstrat 2 bestückt und über Bonddrähte mit den Leiterbahnen kontaktiert werden als auch als gehäuste SMD-Bauelemente auf die Leiterplatte bestückt, geklebt und im Reflow-Lötverfahren mit den Leiterbahnen elektrisch verbunden werden. Die über die Leiterbahnen des Leiterplatten-Trägersubstrats 2 untereinander verbundenen elektronischen Bauelemente 10, 11 und 12 bilden eine elektronische Steuerschaltung. Im vorliegenden Fall bilden sie eine Getriebesteuerschaltung (TCU = Transmission Control Unit).

Wie in Fig. 1 weiterhin zu erkennen ist, kann das Leiterplatten-Trägersubstrat 2 von der ersten Seite 22 bis zur zweiten Seite 21 durchgehende Ausnehmungen 23 aufweisen, in die beispielweise Sockelteile 5a, 5b eingesetzt sind. Die Sockelteile 5a, 5b können Zapfen 55 aufweisen, welche beispielsweise in die Ausnehmungen 23 des Leiterplatten-Trägersubstrats 2 fest eingepresst oder eingerastet sind. Die Sockelteile 5a, 5b können mittels eines Kragens 54 an der ersten Seite 22 des Leiterplatten-Trägersubstrats 2 anliegen. In Fig. 1 sind beispielsweise nur zwei Sockelteile 5a und 5b gezeigt. Natürlich können mehr als zwei Sockelteile oder auch nur ein Sockelteil vorgesehen sein. Die Sockelteile dienen vorteilhaft der Fixierung jeweils einer flexiblen Leiterfolie 4a, 4b. Jedoch sind die Sockelteile 5a, 5b nicht unbedingt erforderlich und die flexiblen Leiterfolien 4 können auch ohne Sockelteile an dem Leiterplatten-Trägersubstrat 2 befestigt werden.

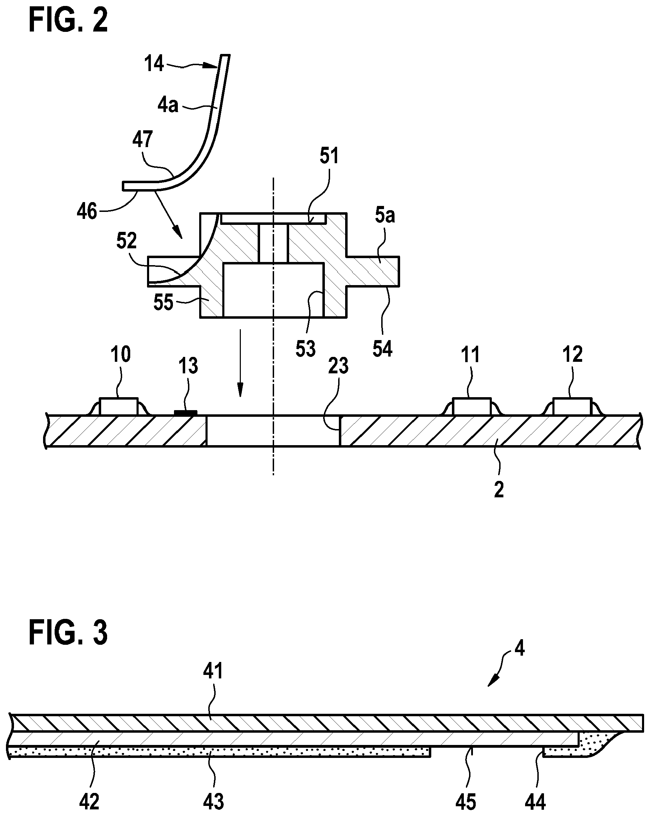

Erfindungsgemäß werden flexible Leiterfolien 4 zur elektrischen Leitungsanbindung 14 von Sensoren, Steckern und andern Komponenten an die elektronische Steuerschaltung verwandt. Vorzugsweise wird jede Komponente über jeweils eine eigene flexible Leiterfolie 4 an die elektronische Steuerschaltung elektrisch kontaktiert. Es ist aber auch möglich zwei oder mehr Komponenten über eine gemeinsame flexible Leiterfolie mit dem Leiterplatten-Trägersubstrat 2 zu kontaktieren. Die zur Leitungsanbindung 14 eingesetzten flexiblen Leiterfolien 4 können den in Fig. 3 dargestellten Aufbau aufweisen. Wie in Fig. 3 zu erkennen ist, weisen die flexible Leiterfolien 4 wenigstens eine erste Lage aus einer flexiblen Trägerfolie 41 aus glasfaserverstärktem Harz, wenigstens eine zweite Lage mit auf die Trägerfolie aufgebrachten Leiterbahnen 42 aus vorzugsweise Kupfer sowie eine dritte Lage aus einer Deckschicht 43 aus einem glasfaserverstärktem Harz, einer Harzschicht oder einem Harzlack auf. Gegebenenfalls kann die flexible Leiterfolie zwischen der Trägerfolie 41 und der Deckschicht 43 auch mehr als eine Leiterbahnlage aufweisen. Somit unterscheiden sich die hier vorzugsweise verwandten flexiblen Leiterfolien 4 von den im Stand der Technik oft eingesetzten gängigen flexiblen Leiterfolien, welche Polyimid als Trägerfolie verwenden.

Vorzugsweise weisen das in der flexiblen Trägerfolie 41 enthaltene Harz und das Harz oder der Harzlack der Deckschicht 43 das gleiche Harzmaterial auf, insbesondere ein Epoxidharz. Dies ist aber nicht zwingend erforderlich. Die Trägerfolie 41 besteht vorzugsweise aus einer glasfaserverstärkten Epoxidharzschicht mit einer Dicke von 100 bis 200 µm. Obwohl dies das gleiche oder zumindest ein ähnliches FR4-Material ist, aus dem auch das starre und harte Leiterplatten-Trägersubstrat 2 gefertigt ist, können die Lagen 41, 42 und 43 so dünn ausgebildet sein, dass die flexible Leiterfolie 4 biegeschlaff ist daher wie ein normale flexible Leiterfolie biegbar und verformbar ist. Die Kupferleiterbahnen 42 können ähnlich zur Leiterplattentechnik direkt auf der Trägerfolie 41 erzeugt werden. Die Deckschicht 43 wird als dünner Lack aufgetragen oder als dünne Trägerfolie aufgebracht.

Wie in Fig. 3 weiterhin zu erkennen ist, ist zur Kontaktierung der Leiterbahn 42 an den dafür vorgesehen Stellen jeweils ein Fenster beziehungsweise eine Aussparung 44 in der Deckfolie 43 vorgesehen, durch welche eine Kontaktfläche 45 der Leiterbahn 42 von außen zugänglich ist.

Die flexible Leiterfolie 4 weist einen ersten Endabschnitt 46 auf. An dem ersten Endabschnitt 46 ist eine freiliegende Kontaktfläche 45 der flexiblen Leiterfolie 4 mit einer Kontaktstelle 13, die unmittelbar auf dem Leiterplatten-Trägersubstrat 2 angeordnet ist, durch Löten oder mittels eines Leitklebers direkt elektrisch verbunden. Bonddrähte sind hierzu nicht erforderlich. Ein sich jeweils an den Endabschnitt 46 anschließender Verbindungsabschnitt 47 der flexiblen Leiterfolien 4a und 4b ist jeweils an eine in Fig. 2 gut erkennbare Führungsfläche 52 eines Sockelteils 5a, 5b angelegt und beispielsweise mittels eines Klebers daran gefestigt. Der Verbindungabschnitt 47 kann aber auch in anderer Weise an der Führungsfläche 52 fixiert sein. Beispielsweise könnte der Verbindungsabschnitt 47 in seitliche Führungsnuten des Sockelteils 5a, 5b eingeschoben sein oder auf einen Kunststoff-Dorn aufgefädelt sein und/oder mittels Warmnieten an der Führungsfläche 52 befestigt sein. Durch die Anlage der flexiblen Leiterfolie 4a, 4b an dem jeweiligen Sockelteil 5a, 5b wird die flexible Leiterfolie in Bezug auf das Leiterplatten-Trägersubstrat 2 ausgerichtet. Die Führungsfläche 52 ist hierzu beispielsweise gekrümmt ausgebildet und bildet dadurch quasi eine Schanze für die flexible Leiterfolie. Dadurch kann vorteilhaft erreicht, werden, dass ein durch die Führungsfläche definierter Austrittswinkel α und/oder Austrittsort 49 der jeweiligen flexiblen Leiterfolie 4a 4b aus dem Harzverguss 3 gebildet wird. Die Sockelteile 5a, 5b können aus thermoplastischen Material, aus Duroplast oder Metall oder einem anderen Material ausgebildet werden.

Auf der ersten Seite 22 des Leiterplatten-Trägersubstrats 2 ist ein Harzverguss 3 angeordnet. Der Harzverguss 3 ist vorteilhaft aus dem gleichen Harzmaterial hergestellt, das auch die Trägerfolie 41 und die Deckschicht 43 der flexiblen Leiterfolie 4 aufweist, im vorliegenden Beispiel also aus einem Epoxidharz. Der Harzverguss 3 deckt die elektronischen Bauelemente 10, 11, 12 auf der ersten Seite 21 des Leiterplatten-Trägersubstrats 2 vollständig ab und bildet dabei ein die elektronische Steuerschaltung schützendes hartes Gehäuseteil 7. Unter einem harten Gehäuseteil wird in diesem Kontext ein Gehäuseteil verstanden, das im Unterschied zu einer weichen Abdeckung mit einem Gel gegen mechanische Beanspruchungen wie Stöße und Schläge unnachgiebig ausgebildet ist. Der Harzverguss 3 kann durch einen Dispensvorgang aufgebracht werden und anschließend beispielsweise thermisch oder mittels Strahlungsenergie ausgehärtet wird. Ein Spritzguss- oder Mold-Werkzeug ist hierfür nicht erforderlich. Durch die innige Verbindung der flexiblen Leiterfolie 4 mit dem Harzverguss 3 kann kein Medium in den Kontaktbereich von Leiterfolie und Harzverguss eindringen. Das Leiterplatten-Trägersubstrat ist daher gut geschützt.

Wie in Fig. 1 weiterhin zu erkennen ist, ist der Harzverguss in einer Höhe, welche etwa der Höhe des Sockelteils 5a entspricht, auf das Leiterplatten-Trägersubstrat 2 aufgetragen, so dass eine von dem Leiterplatten-Trägersubstrat 2 abgewandte Montagefläche 51 des Sockelteils 5a nicht mit dem Harzverguss 3 bedeckt ist. Im Unterschied dazu ist das Sockelteil 5b auf der ersten Seite 22 des Leiterplatten-Trägersubstrat 2 vollständig in den Harzverguss 3 eingebettet. Beide dargestellte Sockelteile 5a, 5b sind in dem Harzverguss 3 fest eingebettet.

Wie in Fig. 1 weiterhin zu erkennen ist, ist beispielsweise ein Podest 9 zur Anbindung einer nicht in den Harzverguss 3 eingebetteten elektrischen Komponente 6 vorgesehen. Natürlich können auch mehrere Podeste vorgesehen sein. Das Podest 9 weist als elektrische Komponente 6 ein in eine Kunststoffmasse eingebettetes Sensorelement 66 auf, bei dem es sich beispielsweise um einen Sensor-ASIC, einen Sensor-IC, insbesondere einen Hall-IC handeln kann. Vorzugsweise ist das Podest 9 aus einem duroplastischen oder thermoplastischen Kunststoff ausgebildet. Das Sensorelement 66 ist dicht in den Kunststoff gemoldet oder darin eingespritzt. Anschlusselemente 61 des Sensorelementes 66 sind ebenfalls in den Kunststoff des Podests 9 dicht eingebettet. Ein Endabschnitt der Anschlusselemente 61 ist an einer Seitenwand des Podests 9 nicht in den Kunststoff eingebettet und bildet jeweils ein an dem Podest zugängliches Kontaktelement 62.

Das Podest 9 ist auf die Montagefläche 51 des Sockelteils 5a aufgesetzt oder aufgesteckt und beispielsweise mittels schraubbarer Befestigungsmittel 8, die von der zweiten Seite 21 des Leiterplatten-Trägersubstrats 2 in das Sockelteil 5a eingesetzt sind, an das Sockelteil 5a angeschraubt. Es ist aber auch möglich, das Podest 9 durch Heissgas-Schmelzen, Laserschweißen, Warmverstemmen oder Warmnieten mit dem Sockelteil 5a zu verbinden. Ein sich an den Verbindungsabschnitt 47 der flexiblen Leiterfolie 4a anschließender zweiter Endabschnitt 48 der flexiblen Leiterfolie ist seitlich an das Podest 9 angelegt, wobei eine dort freiliegende Kontaktfläche 45 der flexiblen Leiterfolie 4a jeweils mit einem Kontaktelement 62 der Anschlusselemente 61 des Sensorelementes 66 elektrisch kontaktiert ist. Dieser elektrische Kontakt kann beispielsweise durch Stempellöten, Laserlöten oder Leitkleben hergestellt sein. Für jedes Sensorelement 66 sind beispielsweise zwei Anschlusselemente 61 vorgesehen. Vorzugsweise umfasst die flexible Leiterfolie 4a daher wenigstens zwei Leiterbahnen 45. Als Sensorelemente 66 können preisgünstige Standardbauteile mit standardisierter Schnittstellen verwandt werden. Ene Anpassung an den jeweiligen Einbauort des Sensorelementes (also Abstand und Lage relativ zu dem Leiterplatten-Trägersubstrat 2) kann durch geeignete Gestaltung des Podestes 9 erreicht werden.

Wie in Fig. 2 außerdem dargestellt ist, kann eine flexible Leiterfolie 4b auch mit dem freiliegenden zweiten Endabschnitt 48 mit einem als elektrische Komponente 6 vorgesehenen Steckerteil 67 kontaktiert sein. Natürlich können mehrere Steckerteile vorgesehen sein. Das Steckerteil 67 ist hier beispielsweise eine elektrische Komponente 6 des Steuermoduls 1, die nicht über ein Podest an dem Steuermodul befestigt ist, sondern nur über die flexible Leiterfolie 4b. Das Steckerteil 67 kann dem externen Anschluss des Steuermoduls dienen oder aber zu Kontaktierung eines Aktuators vorgesehen sein, beispielsweise zur Kontaktierung eines Druckregelventils.

Bei der Herstellung des elektronischen Sensormoduls kann wie folgt verfahren werden. Zunächst wird das Leiterplatten-Trägersubstrats 2 mit den elektronischen Bauelementen 10, 11, 12 der elektronischen Steuerschaltung bestückt. Gegebenenfalls werden die Ausnehmungen 23 zur Aufnahme der Sockelteile 5a, 5b in das Leiterplatten-Trägersubstrat 2 einbracht. Außerdem werden die Leitungsverbindungen 14, welche jeweils eine flexible Leiterfolie 4a, 4b umfassen und die Sockelteile 5a, 5b bereitgestellt.

Es ist möglich, die flexible Leiterfolie 4a, 4b vor der Herstellung eines elektrischen Kontaktes zwischen dem ersten Endabschnitt 46 der flexiblen Leiterfolie 4a, 4b und der auf dem Leiterplatten-Trägersubstrat 2 angeordneten elektrische Kontaktstelle 13 an dem zugeordneten Sockelteil 5a, 5b zu befestigen und anschießend erst die Sockelteile 5a, 5b zusammen mit den flexiblen Leiterfolien 4a, 4b auf das Leiterplatten-Trägersubstrat 2 zu bestücken. Alternativ werden zunächst die Sockelteile 5a, 5b auf das auf das Leiterplatten-Trägersubstrat 2 bestückt und danach die flexiblen Leiterfolien 4a, 4b an den Sockelteilen 5a, 5b beispielsweise durch Kleben befestigt.

Flexible Leiterfolien 4, die kein Sockelteil benötigen, werden direkt auf das Leiterplatten-Trägersubstrat 2 aufgebracht.

Nach der Aufbringung der flexiblen Leiterfolie erfolgt die Herstellung eines direkten elektrischen Kontaktes zwischen dem ersten Endabschnitt 46 der flexiblen Leiterfolie 4a, 4b (beziehungsweise der Kontaktfläche 45 der flexiblen Leiterfolie 4a, 4b) und der auf dem Leiterplatten-Trägersubstrat 2 angeordneten elektrischen Kontaktstelle 13 durch Löten, Leitkleben oder in anderer geeigneter Weise.

Erst danach wird ein Harzverguss 3 hergestellt, der über den elektronischen Bauelementen 10, 11, 12 und der elektrischen Kontaktstelle 13 auf das Leiterplatten-Trägersubstrat 2 aufgetragen wird. Der Harzverguss 3 bildet nach seiner Herstellung ein die elektronischen Bauelemente 10, 11, 12 und die Kontaktstelle 13 abdeckendes und gegenüber dem Außenraum schützendes, hartes Gehäuseteil 7. Der Harzverguss 3 kann durch einen Dispensvorgang aufgebracht werden und anschließend beispielsweise thermisch oder mittels Strahlungsenergie ausgehärtet wird. Ein Spritzguss- oder Mold-Werkzeug ist nicht erforderlich. Der sich an den ersten Endabschnitt 46 anschließende Verbindungsabschnitt 47 der flexiblen Leiterfolien 4a 4b steht wenigstens abschnittsweise in direkten Kontakt zu dem Harzverguss 3 und ragt aus dem Harzverguss 3 heraus.

Zum Schluss wird das Podest 9 auf das Sockelteil 5a aufgesetzt und der sich an den Verbindungsabschnitt 47 anschließende zweite Endabschnitt 48 der flexiblen Leiterfolie 4a mit den Anschlusselementen 61 des Sensorelementes 66 kontaktiert. Das wenigsten eine Steckerteil 67 kann vor oder nach der Kontaktierung der flexiblen Leiterfolie 4b mit dem Leiterplatten-Trägersubstrat 2 mit dem Endabschnitt 48 der flexiblen Leiterfolie 4b kontaktiert werden.

## Patentansprüche

1. Elektronisches Steuermodul (1) mit einem Leiterplatten-Trägersubstrat (2), auf dem elektronische Bauelemente (10, 11, 12) einer elektronischen Steuerschaltung angeordnet sind und mit einem zum Schutz der elektronischen Steuerschaltung auf dem Leiterplatten-Trägersubstrat (2) über den elektronischen Bauelementen (10, 11, 12) angeordneten Harzverguss (3), wobei der Harzverguss (3) ein die elektronischen Bauelemente (10, 11, 12) abdeckendes und gegenüber dem Außenraum schützendes, hartes Gehäuseteil (7) bildet, und mit wenigstens einer Leitungsanbindung (14) an eine außerhalb des Harzvergusses (3) angeordnete elektrische Komponente (6) des Steuermoduls (1), wobei die wenigstens eine Leitungsanbindung (14) eine flexible Leiterfolie (4, 4a 4b) umfasst, wobei die flexible Leiterfolie (4, 4a, 4b) mit einem ersten Endabschnitt (46) an eine innerhalb des Harzvergusses (3) auf dem Leiterplatten-Trägersubstrat (2) angeordnete elektrische Kontaktstelle (13) elektrisch angebunden ist, wobei ein sich an den ersten Endabschnitt (46) anschließender Verbindungsabschnitt (47) der flexiblen Leiterfolie (4, 4a 4b) durch den Harzverguss (3) hindurch und wenigstens abschnittsweise in direkten Kontakt zu dem Harzverguss (3) nach außen geführt ist und wobei ein sich an den Verbindungsabschnitt (47) anschließender zweiter Endabschnitt (48) der flexiblen Leiterfolie (4, 4a, 4b) außerhalb des Harzvergusses (3) mit der elektrischen Komponente (6) elektrisch verbunden ist.

2. Elektronisches Steuermodul nach Anspruch 1, **dadurch gekennzeichnet, dass** die flexible Leiterfolie (4, 4a, 4b) wenigstens eine erste Lage aus einer flexiblen Trägerfolie (41) aus glasfaserverstärktem Harz, wenigstens eine zweite Lage mit auf die Trägerfolie aufgebrachten Leiterbahnen (42) und eine dritte Lage aus einer Deckschicht (43) aus einem glasfaserverstärktem Harz, einer Harzschicht oder einem Harzlack aufweist.

3. Elektronisches Steuermodul nach Anspruch 1, **dadurch gekennzeichnet, dass** das in dem Harzverguss (3) enthaltene Harz, das in der flexiblen Trägerfolie (41) enthaltene Harz und das Harz oder der Harzlack der Deckschicht (43) das gleiche Harzmaterial, insbesondere ein Epoxidharz aufweisen.

4. Elektronisches Steuermodul nach einem der vorstehenden Ansprüche, **dadurch gekennzeichnet, dass** innerhalb des mit dem Harzverguss (3) abgedeckten Teils des Leiterplatten-Trägersubstrats (3) wenigstens ein Sockelteil (5a, 5b) auf dem Leiterplatten-Trägersubstrat (2) angeordnet ist und dass der Verbindungsabschnitt (46) der flexiblen Leiterfolie (4, 4a, 4b) an dem Sockelteil (5a, 5b) angeordnet, insbesondere befestigt ist.

5. Elektronisches Steuermodul nach Anspruch 4, **dadurch gekennzeichnet, dass** an dem Sockelteil (5a, 5b) eine Führungsfläche (52) ausgebildet ist und dass durch eine Anlage des Verbindungsabschnitt (47) der flexiblen Leiterfolie (4, 4a, 4b) an der Führungsfläche (52) des Sockelteils (5a, 5b) ein Austrittswinkel (α) und/oder Austrittsort (49) der flexiblen Leiterfolie (4, 4a 4b) aus dem Harzverguss (3) bestimmt wird.

6. Elektronisches Steuermodul nach Anspruch 4 oder 5, **dadurch gekennzeichnet, dass** das auf dem Leiterplatten-Trägersubstrat (2) angeordnete Sockelteil (5a) durch den Harzverguss (3) nach außen hindurchgeführt ist und eine von dem Leiterplatten-Trägersubstrat (2) abgewandte Montagefläche (51) des Sockelteils (5a) von dem Harzverguss (3) ausgenommen ist und dass die elektrische Komponente (6) an einem Podest (9) angeordnet ist und das Podest (9) an der Montagefläche (51) des Sockelteils (5a) befestigt ist.

7. Elektronisches Steuermodul nach einem der vorstehenden Ansprüche, **dadurch gekennzeichnet, dass** die elektrische Komponente (6) ein Sensor (66) oder ein Steckerteil (67) ist.

8. Elektronisches Steuermodul, **dadurch gekennzeichnet, dass** das elektronische Steuermodul (1) für die Ansteuerung eines Kraftfahrzeuggetriebes geeignet ist.

9. Verfahren zur Herstellung eines elektronisches Steuermoduls (1) nach einem der vorstehenden Ansprüche, **gekennzeichnet durch** folgende Schritte:
- Bereitstellen eines Leiterplatten-Trägersubstrats (2), auf dem elektronische Bauelemente (10, 11, 12) einer elektronischen Steuerschaltung angeordnet sind,
- Bereitstellen wenigstens einer Leitungsverbindung (14), wobei die wenigstens eine Leitungsverbindung (14) eine flexible Leiterfolie (4, 4a, 4b) umfasst,
- Herstellung eines elektrischen Kontaktes zwischen einem ersten Endabschnitt (46) der flexiblen Leiterfolie (4, 4a, 4b) und einer auf dem Leiterplatten-Trägersubstrat (2) angeordneten elektrische Kontaktstelle (13),
- Herstellung eines Harzvergusses (3), der über den elektronischen Bauelementen (10, 11, 12) und der elektrischen Kontaktstelle (13) auf dem Leiterplatten-Trägersubstrat (2) aufgetragen wird, wobei der Harzverguss (3) nach seiner Herstellung ein die elektronischen Bauelemente (10, 11, 12) und die Kontaktstelle (13) abdeckendes und gegenüber dem Außenraum schützendes, hartes Gehäuseteil (7) bildet und wobei ein sich an den ersten Endabschnitt (46) der flexiblen Leiterfolie (4, 4a 4b) anschließender Verbindungsabschnitt (47) der flexiblen Leiterfolie (4, 4a 4b) **durch** den Harzverguss (3) hindurch und wenigstens abschnittsweise in direkten Kontakt zu dem Harzverguss (3) nach außen absteht,
- Herstellen einer elektrischen Verbindung zwischen einem sich an den Verbindungsabschnitt (47) anschließenden zweiten Endabschnitt (48) der flexiblen Leiterfolie (4, 4a, 4b) und einer elektrischen Komponente (6) außerhalb des Harzvergusses (3).

10. Verfahren nach Anspruch 9, **dadurch gekennzeichnet, dass** vor dem Schritt der Herstellung eines elektrischen Kontaktes zwischen dem ersten Endabschnitt (46) der flexiblen Leiterfolie (4, 4a 4b) und der auf dem Leiterplatten-Trägersubstrat (2) angeordneten elektrische Kontaktstelle (13) ein Sockelteil (5a, 5b) bereitgestellt wird und die flexible Leiterfolie (4, 4a, 4b) mit dem Verbindungsabschnitt (47) an dem Sockelteil (5a, 5b) angeordnet, insbesondere dort befestigt wird.

11. Verfahren nach Anspruch 10, **dadurch gekennzeichnet, dass** das Sockelteil (5a, 5b) vor oder nach der Befestigung des Verbindungsabschnittes (47) an dem Sockelteil (5a, 5b) auf das Leiterplatten-Trägersubstrat (2) bestückt wird.
